(19) Europäisches Patentamt
European Patent Office
Office européen des brevets

(11) **EP 3 736 982 A1**

(12) **EUROPÄISCHE PATENTANMELDUNG**

(43) Veröffentlichungstag:
**11.11.2020 Patentblatt 2020/46**

(51) Int Cl.:
***H03K 17/082*** (2006.01)　***H03K 17/16*** (2006.01)

(21) Anmeldenummer: **19172967.2**

(22) Anmeldetag: **07.05.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft**
**80333 München (DE)**

(72) Erfinder:
• **Krümmer, Bastian**
**91054 Erlangen (DE)**
• **Kunert, Andreas**
**90522 Oberasbach (DE)**
• **Stadter, Norbert**
**96155 Buttenheim (DE)**

(54) **ADAPTIVE SCHALTGESCHWINDIGKEITSSTEUERUNG VON LEISTUNGSHALBLEITERN**

(57) Die Erfindung betrifft eine Halbleiterschaltvorrichtung (1), umfassend einen schaltbaren Leistungshalbleiter ($T_2$) sowie mindestens eine Regelschaltung (RS1, RS2), die eine Stromsenke ($S_1$,$S_2$) und einen Stromverstärker ($V_1$,$V_2$) umfasst. Die Stromsenke ($S_1$,$S_2$) ist kapazitiv über einen Regelkondensator ($C_1$) mit dem Kollektor des Leistungshalbleiters ($T_2$) gekoppelt und zur Ableitung eines Teilstromes des bei einem Schaltvorgang über den Regelkondensator ($C_1$) fließenden Stromes bis zu einem einstellbaren Maximalstrom eingerichtet. Der Stromverstärker ($V_1$,$V_2$) ist eingangsseitig mit dem kapazitiv mit dem Regelkondensator ($C_1$) gekoppelten Ende der Stromsenke ($S_1$,$S_2$) und mit einer positiven oder mit einer negativen Versorgungsspannung und ausgangsseitig mit der Gateelektrode des Leistungshalbleiters ($T_2$) verbunden und derart eingerichtet, dass der von der Stromsenke ($S_1$,$S_2$) nicht abgeleitete Teilstrom des bei einem Schaltvorgang über den Regelkondensator ($C_1$) fließenden Stromes verstärkt und in die Gateelektrode des Leistungshalbleiters ($T_2$) derart eingeleitet wird, dass der Änderung der Spannung über der Kollektor-Emitter-Strecke des Leistungshalbleiters ($T_2$) bei einem Schaltvorgang entgegengewirkt wird.

FIG 3

**Beschreibung**

Die Erfindung betrifft eine Halbleiterschaltvorrichtung umfassend einen schaltbaren Leistungshalbleiter und eine adaptive Schaltgeschwindigkeitssteuerung zur Steuerung der Schaltgeschwindigkeit des Leistungshalbleiters.

Derartige Halbleiterschaltvorrichtungen kommen beispielsweise in Frequenzumrichtern zum Einsatz, die in der Antriebstechnik verwendet werden, wobei der schaltbare Leistungshalbleiter als Bipolartransistor mit isolierter Gateelektrode (IGBT) ausgebildet ist.

Die Schaltgeschwindigkeit von Leistungshalbleitern wird üblicherweise nach zwei gegensätzlichen Kriterien gewählt. Einerseits soll zur Minimierung von Schaltverlusten unter Voraussetzung eines sicheren Betriebs der Leistungshalbleiter möglichst schnell geschaltet werden. Andererseits soll zur Vermeidung elektromagnetischer Emissionen und zur Verbesserung der elektromagnetischen Verträglichkeit (EMV) die Schaltgeschwindigkeit des Leistungshalbleiters begrenzt werden.

Das Kriterium minimaler Schaltverluste und das Kriterium minimaler elektromagnetischer Verträglichkeit sind einander widersprechende Entwurfsziele und können zudem nicht unter Berücksichtigung aller Betriebsparameter in gleichem Maß umgesetzt werden.

Beispielhaft ändern sich beim Einschalten eines als IGBT ausgebildeten Leistungshalbleiters die Schaltverluste und die Spannungssteilheit (Veränderung der Spannungsänderung während des Schaltvorgangs) mit zunehmendem Ausschaltstrom gegenläufig.

Beim Ausschalten eines solchen IGBT nehmen dagegen Spannungssteilheit und Schaltverluste etwa gleichläufig mit zunehmendem Ausschaltstrom zu.

Daher sowie wegen der erforderlichen Berücksichtigung weiterer Betriebsparameter muss beim Festlegen der Schaltgeschwindigkeit eines Leistungshalbleiters immer ein Kompromiss gefunden werden. Bei Ausdehnung der Betriebsbedingungen müssen, damit ein Betrieb in Randbereichen der Betriebsparameter noch möglich ist, mit Halbleiterschaltvorrichtungen nach dem Stand der Technik Leistungs- und/oder Effizienzverluste hingenommen werden.

Das Dokument DE 102 11 075 A1 beschreibt eine geregelte Ansteuerschaltung für einen analog angesteuerten Leistungshalbleiter umfassend einen digital arbeitenden Logikbaustein mit einem Steuereingang, an den über einen A/D Wandler Steuersignale zuführbar sind, mit denen das digitale Ausgangssignal des Logikbausteins beeinflussbar ist, das auf einen Baustein oder eine Baugruppe zur Wandlung dieses Ausgangssignals in eine analoge oder quasi-analoge Steuergröße für den Leistungshalbleiter geschaltet ist.

Das Dokument DE 10 2005 012 151 B3 beschreibt ein Verfahren und eine Schaltungsanordnung zur Ein- und Ausschaltsteuerung von Leistungshalbleiterschaltern mit vorgeschalteter Steuerstufe und Optimierung der Schaltgeschwindigkeit beim Ein- und Ausschalten, wobei der Kollektor-Emitter-Strom des Leistungshalbleiterschalters erfasst und die Schaltgeschwindigkeit des nächstfolgenden Einschaltvorgangs in Abhängigkeit von diesem Kollektor-Emitter-Strom gesteuert wird. Eine Steuerstufe ist eine durch das Ansteuersignal für den Leistungshalbleiterschalter gesteuerte Sample-and-Hold-Schaltung zur Speicherung der Kollektor-Emitter-Spannung des Leistungshalbleiterschalters sowie jeweils eine weitere, die Steuerung der Schaltgeschwindigkeit in Abhängigkeit von dem Sample-and-Hold Signal verstellende Steuerstufe für das Ein- und Ausschalten des Leistungshalbleiterschalters vorgeordnet.

Weitere, aus dem Stand der Technik bekannte Verfahren zur Verbesserung der elektromagnetischen Verträglichkeit (EMV) sind EMV-Filter und Abschirmungen. Ferner sind Verfahren zur Verlustabführung, beispielsweise verbesserte Kühlung oder ein höherer Leistungshalbleiteraufwand, bekannt.

Der Erfindung liegt die Aufgabe zugrunde, eine verbesserte Halbleiterschaltvorrichtung und einen verbesserten Frequenzumrichter anzugeben.

Die Aufgabe wird hinsichtlich der verbesserten Halbleiterschaltvorrichtung erfindungsgemäß durch eine Halbleiterschaltvorrichtung mit den Merkmalen des Anspruchs 1 gelöst. Hinsichtlich des verbesserten Frequenzumrichters wird die Aufgabe durch einen Frequenzumrichter mit den Merkmalen des Anspruchs 8 gelöst.

Vorteilhafte Ausgestaltungen der Erfindung sind Gegenstand der Unteransprüche.

Eine Halbleiterschaltvorrichtung umfasst einen über eine Gateelektrode entlang seiner Kollektor-Emitter-Strecke schaltbaren Leistungshalbleiter mit einem Kollektor, einem Emitter und einem Gate sowie mindestens eine Regelschaltung, die über einen Regelkondensator mit der mindestens Regelschaltung verbunden ist.

Eine Regelschaltung umfasst jeweils eine Stromsenke und einen Stromverstärker. Die Stromsenke ist kapazitiv über den Regelkondensator mit dem Kollektor des Leistungshalbleiters gekoppelt und zur Ableitung eines ersten Teilstromes des bei einem Schaltvorgang über den Regelkondensator fließenden Kondensatorstromes bis zu einem einstellbaren Maximalstrom nach Masse eingerichtet. Die Stromsenke ist mit einer einstellbaren Spannungsquelle verbunden und derart eingerichtet, dass der maximal aufnehmbare und nach Masse ableitbare Maximalstrom mittels der einstellbaren Spannungsquelle einstellbar ist. Der Stromverstärker ist eingangsseitig mit dem kapazitiv mit dem Regelkondensator gekoppelten Ende der Stromsenke verbunden und wird mit einer positiven oder mit einer negativen Versorgungsspannung gespeist. Ausgangsseitig ist der Stromverstärker mit der Gateelektrode des Leistungshalbleiters verbunden.

Der Stromverstärker ist derart eingerichtet, dass ein zweiter Teilstrom entsprechend dem Reststrom des bei einem Schaltvorgang über den Regelkondensator fließenden Kondensatorstromes, der von der Stromsenke nicht abgeleitet wird, eingangsseitig aufgenommen und um einen vorbestimmten Verstärkungsfaktor verstärkt und in die Gateelektrode des Leistungshalbleiters derart eingeleitet wird, dass der Änderung der Spannung über der Kollektor-Emitter-Strecke des Leistungshalbleiters bei einem Schaltvorgang entgegengewirkt wird.

Mittels der einstellbaren Spannungsquelle kann somit die Steilheit der Spannungsänderung der Kollektor-Emitter-Spannung bei einem Schaltvorgang am Leistungshalbleiter gesteuert werden, indem bei hoher Spannung der einstellbaren Spannungsquelle ein geringer Reststrom des Kondensatorstroms verstärkt und in die Gateelektrode des Leistungshalbleiters eingeleitet wird und entsprechend bei niedriger Spannung der einstellbaren Spannungsquelle ein hoher Reststrom des Kondensatorstroms verstärkt und in die Gateelektrode des Leistungshalbleiters eingeleitet wird.

In vorteilhafter Weise kann somit in jedem Betriebspunkt des Leistungshalbleiters eine in Bezug auf die Betriebsparameter und/oder die Verlustleistung beim Schaltvorgang und/oder die elektromagnetische Verträglichkeit optimale Schaltgeschwindigkeit eingestellt werden. Damit werden kritische Betriebspunkte, beispielsweise der Abriss einer Freilaufdiode bei deren Abschalten, die Abschaltüberspannung beim Ausschalten des Leistungshalbleiters oder der Start des Leistungsteils bei niedrigen Temperaturen, besser beherrscht als mit Vorrichtungen und Verfahren nach dem Stand der Technik.

Die im Grenzbetrieb, beispielsweise bei sehr geringem oder sehr hohem Kollektor-Emitter-Strom des Leistungshalbleiters, auftretenden Erscheinungen, beispielsweise eine hohe Spannungssteilheit oder hohe Schaltverluste, werden durch die erfindungsgemäße Lösung unkritischer.

Die Performance des Leistungsteils wird verbessert, da nun ein höherer Freiheitsgrad für die Auslegungskriterien bezüglich der Schaltgeschwindigkeit bereitgestellt ist. Damit werden Schaltverluste verringert und/oder die elektromagnetische Verträglichkeit verbessert. Dadurch können Kosten bezüglich EMV-, Halbleiter- und Kühlaufwand reduziert werden.

Die Schaltgeschwindigkeit kann für Applikationen, die Restriktionen bezüglich Spannungssteilheiten am Leistungsteilausgang stellen, auf ein Maximum eingeschränkt werden. Hierbei kann beispielsweise auf ein Spannungssteilheitsfilter verzichtet werden. Hardwaregleiche Leistungsteile können per Einstellung in der Software für unterschiedliche Applikationen ertüchtigt und damit veräußert werden. Dadurch wird die Variantenvielfalt reduziert.

Gegenüber einer adaptiven Schaltgeschwindigkeitssteuerung, bei der die Schaltgeschwindigkeit mittels Gate-Widerständen, Konstantstrom oder Spannungsrampe variiert wird, bietet die Erfindung den Vorteil, dass die Schaltzeitpunkte bei Adaption kaum verändert werden. So bleiben die Schaltverzugszeiten annähernd konstant, da erst nach Auftreten der Spannungssteilheit in das Schaltverhalten eingegriffen wird, sodass nur die angepasste Spannungssteilheit selbst einen Einfluss auf den abgeschlossenen Schaltvorgang hat.

Dadurch hat diese Lösung kaum negativen Einfluss auf das Verhalten des Reglers einer übergeordneten Steuerung, da die auszugebende Spannung kaum durch zusätzliche Verzugszeit verändert wird.

Zudem kann die Verriegelungszeit (das heißt: die Totzeit zwischen unteren und oberen Leistungshalbleitern einer Halbbrücke) ohne Rücksichtnahme auf eine variable Verzugszeit festgelegt werden, womit diese Verriegelungszeit geringer ausfällt und eine erfindungsgemäße Halbleiterschaltvorrichtung auch für höhere Schaltfrequenzen geeignet ist, da der durch die Totzeit bedingte Spannungsverlust verringert wird.

Kosten, Platzbedarf und Komplexität dieser Erfindung sind gegenüber einer rein digitalen Lösung deutlich geringer. Darüber hinaus kann aufgrund geringen Bauteilaufwands mit einer geringeren Ausfallwahrscheinlichkeit gerechnet werden.

Die Schaltung der Erfindung weist ferner eine gute Dynamik auf, um schnelle Schaltvorgänge zu regeln. Der simultane Eingriff der mindestens einen erfindungsgemäßen Regelschaltung direkt am Gate des Leistungshalbleiters während der Steuerung des Schaltvorgangs durch ein davon unabhängiges Treibersignal bietet den Vorteil, dass dieser Eingriff in beide Richtungen niederohmig ist.

Beispielsweise wird die Gateelektrode des Leistungshalbleiters beim Ausschalten über den Ausschaltwiderstand in Richtung der negativen Versorgungsspannung gezogen, während die mindestens eine erfindungsgemäße Regelschaltung gleichzeitig in Richtung der positiven Versorgungsspannung zieht. Dadurch wird eine hohe Verstärkung und eine ausreichende Dynamik erreicht, um die Spannungssteilheit zu regeln.

In einer Ausführungsform der Erfindung umfasst die Halbleiterschaltung eine erste Regelschaltung mit einem ersten Stromverstärker und eine zweite Regelschaltung mit einem zweiten Stromverstärker, wobei der erste Stromverstärker mit der negativen Versorgungsspannung verbunden und zur Einspeisung eines negativen Stromes in die Gateelektrode des Leistungshalbleiters eingerichtet ist und der zweite Stromverstärker mit der positiven Versorgungsspannung verbunden und zur Einspeisung eines positiven Stromes in die Gateelektrode des Leistungshalbleiters eingerichtet ist.

Ein Vorteil dieser Ausführungsform besteht darin, dass die Spannungssteilheit sowohl bei Einschaltvorgängen als auch bei Ausschaltvorgängen mittels getrennter einstellbarer Spannungsquellen unabhängig einstellbar ist.

In einer Ausführungsform umfasst eine Stromsenke einen in Stromgegenkopplung geschalteten Metalloxid-Halbleiter-Feldeffekttransistor (MOSFET), einen Stromgegenkopplungswiderstand sowie eine einstellbare Spannungsquelle, wobei die Drainelektrode des MOSFET mit dem Regelkondensator und die Sourceelektrode des MOSFET über den Stromgegenkopplungswiderstand mit Masse verbunden ist und die Gateelektrode des MOSFET von der gegen Masse referenzierten einstellbaren Spannungsquelle gespeist wird.

Derartige Stromsenken sind leicht und mit verfügbaren Bauelementen kostengünstig herstellbar.

In einer Ausführungsform umfasst ein Stromverstärker einen als Sourcefolger geschalteten MOSFET, einen Gatewiderstand, einen Sourcewiderstand sowie eine Diode, wobei die Diode in Durchlassrichtung auf die Gateelektrode des MOSFET weisend zwischen dem Regelkondensator und der Gateelektrode des MOSFET angeordnet ist. Der Gatewiderstand ist zwischen der Gateelektrode des MOSFET und der Gateelektrode des Leistungshalbleiters angeordnet. Der Sourcewiderstand ist zwischen der Sourceelektrode des MOSFET und der Gateelektrode des Leistungshalbleiters angeordnet.

Derartige Stromverstärker sind leicht und mit verfügbaren Bauelementen kostengünstig herstellbar.

In einer Ausführungsform weist ein Stromverstärker anstelle eines als Sourcefolger geschalteten einen als Emitterfolger geschalteten Bipolartransistor auf, wobei jeweils die Gateelektrode des MOSFET durch die Basis- oder Gateelektrode des Bipolartransistors, die Drainelektrode des MOSFET durch die Kollektorelektrode des Bipolartransistors und die Sourceelektrode des MOSFET durch die Emitterelektrode des Bipolartransistors ersetzt ist.

Ein Bipolartransistor weist gegenüber einem MOSFET ein gutes Durchlassverhalten, eine hohe Sperrspannung und eine hohe Robustheit auf.

In einer Ausführungsform der Erfindung umfasst die Halbleiterschaltvorrichtung eine Zusatzschaltung für einen angepassten Einschaltübergang, die mit der Gateelektrode des Leistungshalbleiters verbunden und die für einen gleitenden Übergang der Kollektorspannung des Leistungshalbleiters beim Umschalten von dessen Kollektor-Emitter-Strecke von einem gesperrten in einen leitenden Zustand eingerichtet ist.

Dadurch kann die Spannungssteilheit der Kollektor-Emitter-Spannung des Leistungshalbleiters, welche aufgrund der Reaktionszeit der mindestens einen Regelschaltung und/oder durch die Gate-Streuinduktivität des Leistungshalbleiters beim Einschalten erhöht sein kann, auf einen gewünschten niedrigen Wert begrenzt werden.

In Ausführungsformen der Erfindung ist der Leistungshalbleiter als Bipolartransistor mit isolierter Gateelektrode (IGBT), als Metalloxid-Halbleiter-Feldeffekttransistor (MOSFET), als Siliciumcarbid Metalloxid-Halbleiter-Feldeffekttransistor (SiC MOSFET) oder als Bipolartransistor ausgebildet. Derartige Leistungshalbleiter sind kostengünstig verfügbar und in eine Halbleiterschaltvorrichtung leicht zu integrieren.

Ein Frequenzumrichter umfasst eine Halbleiterschaltvorrichtung in einer der beschriebenen Ausführungsformen, wobei der Leistungshalbleiter als IGBT ausgebildet ist. Derartige Frequenzumrichter eignen sich für Anwendungen in der Antriebstechnik und weisen geringe Schaltverluste sowie eine gute elektromagnetische Verträglichkeit auf.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:

FIG 1        schematisch die Abhängigkeit von Schaltenergie und Spannungssteilheit vom Kollektorstrom beim Einschalten eines Leistungshalbleiters,

FIG 2        schematisch den Zusammenhang zwischen Schaltenergie und Spannungssteilheit beim Ausschalten eines Leistungshalbleiters,

FIG 3        schematisch eine Schaltung zur Regelung der Spannungssteilheit beim Einschalten,

FIG 4        schematisch eine Schaltung zur Regelung der Spannungssteilheit beim Ausschalten,

FIG 5        schematisch eine Ausführungsform einer Stromsenke,

FIG 6        schematisch eine Ausführungsform eines Stromverstärkers,

FIG 7        schematisch eine Simulationsschaltung sowie

FIG 8 bis 11    Simulationsergebnisse für den simulierten Zeitverlauf der Kollektorspannung, des Kollektorstroms und der Gatespannung eines simulierten Schalttransistors für verschiedene, mittels einer einstellbaren Spannungsquelle vorgegebene höchste Spannungssteilheiten.

Einander entsprechende Teile sind in allen Figuren mit den gleichen Bezugszeichen versehen.

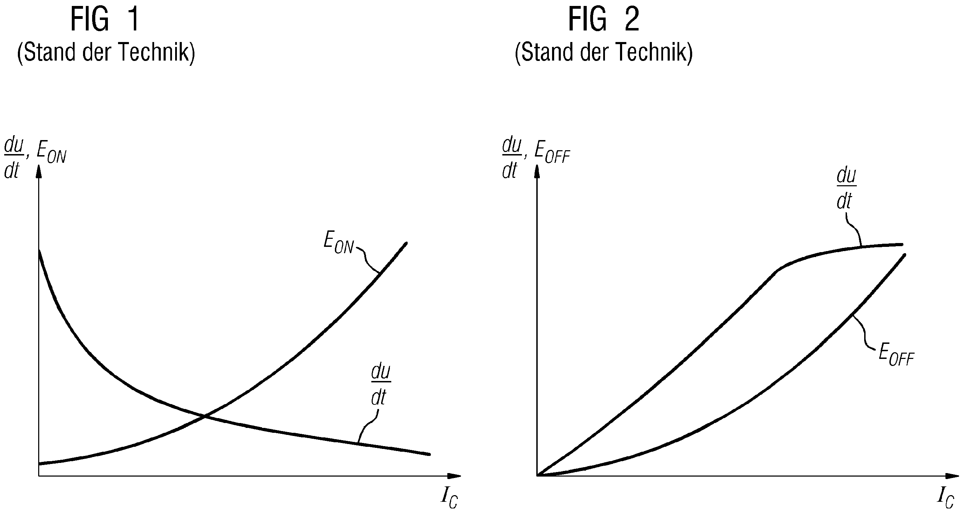

FIG 1 zeigt schematisch die Abhängigkeit der Spannungssteilheit $\frac{du_{CE}}{dt}$ und der Einschaltenergie $E_{ON}$ beim Einschalten eines Leistungshalbleiters, der beispielsweise als Bipolartransistor mit isolierter Gate-Elektrode (insulated-gate bipolar transistor, IGBT) ausgebildet sein kann, von der Stärke des Kollektorstroms $I_C$. Beim Einschalten ändern sich Spannungssteilheit $\frac{du_{CE}}{dt}$ und Einschaltenergie $E_{ON}$ in Abhängigkeit vom geschalteten Kollektorstrom $I_C$ gegenläufig. Mit zunehmendem Kollektorstrom $I_C$ nimmt die Einschaltenergie $E_{ON}$ zu, während die Spannungssteilheit $\frac{du_{CE}}{dt}$ abnimmt.

Wie in FIG 2 dargestellt, ändern sich dagegen beim Ausschalten die Spannungssteilheit $\frac{du_{CE}}{dt}$ und die Ausschaltenergie $E_{OFF}$ gleichläufig: beide Werte nehmen mit zunehmendem geschalteten Kollektorstrom $I_C$ zu.

Außer vom geschalteten Kollektorstrom $I_C$ sind die Schaltenergien $E_{ON}, E_{OFF}$ sowie die Spannungssteilheit $\frac{du_{CE}}{dt}$ zudem von weiteren Parametern abhängig, beispielsweise von der Temperatur und der Zwischenkreisspannung. So wird beispielsweise ein Leistungshalbleiter bei niedriger Temperatur und hoher Zwischenkreisspannung schneller schalten als bei hoher Temperatur und niedriger Zwischenkreisspannung.

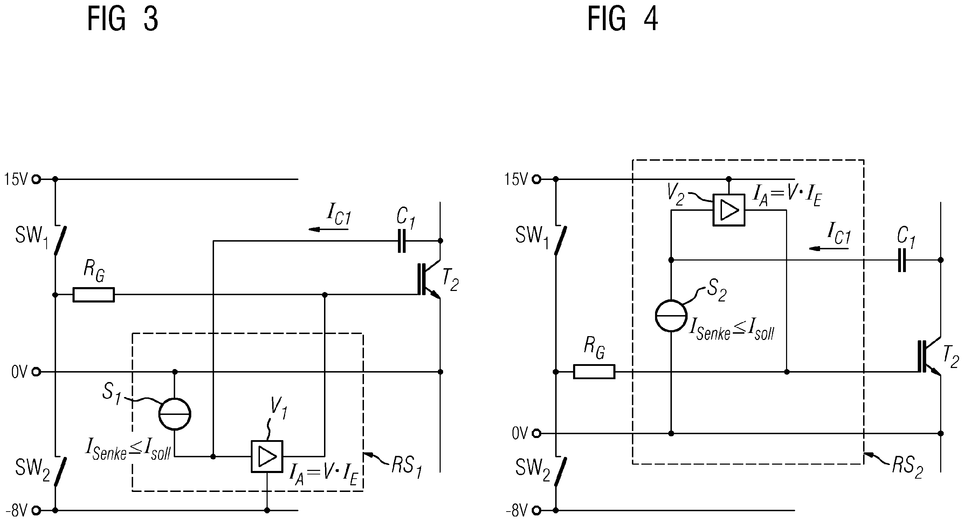

FIG 3 zeigt schematisch eine erste Regelschaltung RS1 zur Regelung der Steilheit einer Kollektorspannung $\frac{du}{dt}$ beim Einschalten eines Schalttransistors $T_2$, der als IGBT ausgebildet ist, mittels einer ersten Stromsenke $S_1$ und eines ersten Stromverstärkers $V_1$. Der Schalttransistor $T_2$ wird mittels eines ersten und zweiten Schalters SW1, SW2 über einen Schalttransistorgatewiderstand $R_G$ geschaltet. Die beiden Schalter SW1, SW2 schalten alternierend und sind somit mindestens nie gleichzeitig geschlossen.

Erfindungsgemäß ist der Kollektor des Schalttransistors $T_2$ mit der ersten Stromsenke $S_1$ über einen Regelkondensator $C_1$ kapazitiv gekoppelt. Die erste Stromsenke $S_1$ ist so ausgebildet, dass sie einen Strom bis zu einer Stromschwelle $I \leq I_{Soll}$ vom Regelkondensator $C_1$ aufnimmt und gegen 0V abführt. Den vom Regelkondensator $C_1$ eingespeisten Strom $\max(I_{C1} - I_{Soll}, 0)$ oberhalb der Stromschwelle $I_{Soll}$ nimmt die erste Stromsenke $S_1$ nicht auf. Die von der ersten Stromsenke $S_1$ nicht aufgenommene Stromdifferenz $\Delta I_{C1} = \max(I_{C1} - I_{Soll}, 0)$ wird an den ersten Stromverstärker $V_1$ geleitet und von diesem um einen Verstärkungsfaktor $v$ verstärkt. Der verstärkte Differenzstrom $v \cdot \Delta I_{C1}$ wird in das Gate des Schalttransistors $T_2$ eingespeist.

In analoger Weise zeigt FIG 4 schematisch eine Schaltung zur Regelung der Spannungssteilheit $\frac{du_{CE}}{dt}$ beim Ausschalten des Schalttransistors $T_2$ mittels einer zweiten Regelschaltung RS2, die von einer zweiten Stromsenke $S_2$ und einem zweiten Stromverstärker $V_2$ gebildet wird.

Die Funktionsweise der beiden Schaltungen nach FIG 3 und FIG 4 ist prinzipiell äquivalent und wird im Folgenden anhand der Schaltung nach FIG 4 erklärt.

Dazu wird angenommen, dass der Schalttransistor $T_2$ zu Beginn des Schaltvorgangs eingeschaltet war. Schaltet der erste Schalter SW1 aus und der zweite Schalter SW2 ein, so wird das Gate des Schalttransistors $T_2$ entladen. Der Schalttransistor $T_2$ schaltet aus und die Spannung $u$ am Kollektor des Schalttransistors $T_2$ erhöht sich. Der Regelkondensator $C_1$ leitet die erhöhte Kollektorspannung ab, wobei über den Regelkondensator $C_1$ ein Regelkondensatorstrom

$$I_{C1} = C_1 \cdot \frac{du}{dt} \text{ fließt.}$$

Die zweite Stromsenke $S_2$ nimmt von diesem Strom über den Regelkondensator $C_1$ einen Teilstrom $I_{Senke}$ von höchstens $I_{Soll}$ auf. Der verbleibende Anteil des Stroms von $\Delta I_{C1} = I_{C1} - I_{Senke} = C_1 \cdot \frac{du}{dt} - I_{Senke}$ wird in den zweiten Stromverstärker $V_2$ geleitet und von diesem um den Verstärkungsfaktor $v$ verstärkt. Der Ausgangsstrom des zweiten Stromverstärkers $V_2$ beträgt somit $I_A = v \cdot \Delta I_{C1}$.

Dieser Ausgangsstrom $I_A$ wird in das Gate des Schalttransistors $T_2$ geleitet. Dadurch wird die Gatespannung des Schalttransistors $T_2$ erhöht und somit die Steilheit des Kollektorstromes $I_C$ des nunmehr weniger stark gesperrten Schalttransistors $T_2$ vermindert. Dies bewirkt eine Verringerung der Kollektorspannungssteilheit $\frac{du}{dt}$ und dadurch eine Verringerung des Regelkondensatorstroms $I_{C1}$ über den Regelkondensator $C_1$.

Dadurch nimmt die Spannungssteilheit der Kollektorspannung des Schalttransistors $T_2$ ab.

Für einen als ideal arbeitend angenommenen zweiten Stromverstärker $V_2$ mit einer Verstärkung $v \rightarrow \infty$ stellt sich somit eine Spannungssteilheit von

$$\frac{du}{dt} = \frac{1}{C} \cdot I_{Senke}$$

ein.

Da der von der zweiten Stromsenke $S_2$ höchstens aufnehmbare Teilstrom gemäß $I_{Senke} \leq I_{Soll}$ begrenzt ist, wirkt die Stromschwelle $I_{Soll}$ als Stellgröße der Spannungssteilheit $\frac{du}{dt}$. Überschreitet die Spannungssteilheit beim Schalten den mittels der Stromschwelle $I_{Soll}$ vorgegebenen Grenzwert, so dass

$$\frac{du}{dt} > \frac{1}{C_1} \cdot I_{Soll},$$

so wird die Spannungssteilheit durch den geschlossenen Kreis vom Kollektor des Schalttransistors $T_2$ über den Regelkondensator $C_1$ und den zweiten Stromverstärker $V_2$ auf das Gate des Schalttransistors $T_2$ und über die Übertragungscharakteristik des Schalttransistors $T_2$ wiederum zurück auf dessen Kollektor geregelt.

Wenn die Änderung der Kollektorspannung beim Ausschalten nicht den mittels der Stromschwelle vorgegebenen Maximalwert erreicht, so dass während des gesamten Ausschaltvorgangs $\frac{du}{dt} \leq \frac{1}{C_1} \cdot I_{Soll}$ gilt, so hat die aus der zweiten Stromsenke $S_2$ und dem zweiten Stromverstärker $V_2$ gebildete zweite Regelschaltung RS2 keine Wirkung.

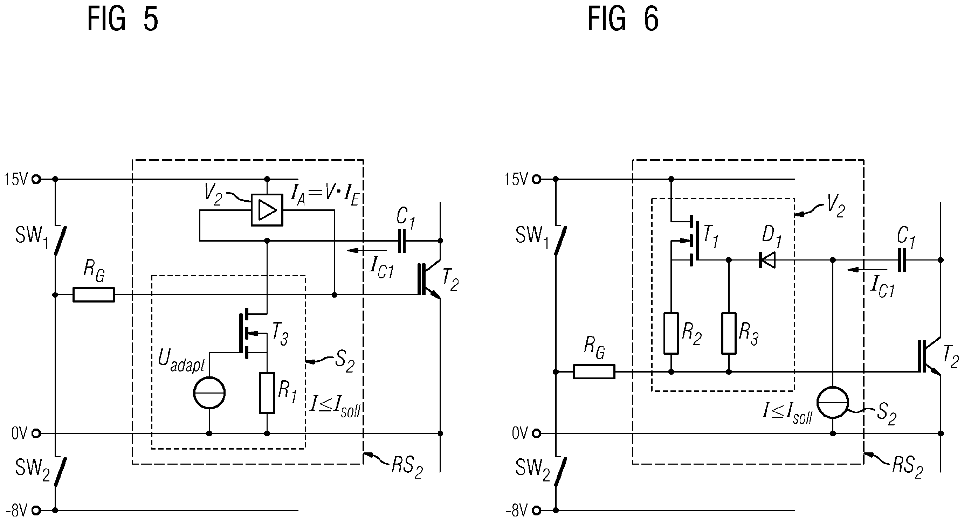

FIG 5 zeigt schematisch eine Ausführungsform für die zweite Stromsenke $S_2$ der zweiten Regelschaltung RS2 zur Begrenzung der Kollektorspannungssteilheit $\frac{du}{dt}$ des Schalttransistors $T_2$ beim Ausschalten. Die zweite Stromsenke $S_2$ umfasst einen Metalloxid-Halbleiter Feldeffekt Transistor (MOSFET) $T_3$, einen Stromgegenkopplungswiderstand $R_1$, der sourceseitig des MOSFET $T_3$ gegen Masse geschaltet ist, sowie eine einstellbare Spannungsquelle $U_{adapt}$, welche die Gatespannung des MOSFET $T_3$ vorgibt. Mit einer positiven Gatespannung der einstellbaren Spannungsquelle $U_{adapt}$ kann die Stromschwelle $I_{Soll}$ eingestellt werden, von der ab der MOSFET $T_3$ in den Linearbetrieb übergeht.

Der von der zweiten Stromsenke $S_2$ aufgenommene Strom $I_{Senke}$ kann in Abhängigkeit von der Spannung der einstellbaren Spannungsquelle $U_{adapt}$, in Abhängigkeit von der Gate-Source-Schwellenspannung $U_{GS(th),3}$ des MOSFET $T_3$ und in Abhängigkeit von dem Stromgegenkopplungswiderstand $R_1$ wie folgt berechnet werden:

$$U_{GS(th),3} + I_{Senke} \cdot R_1 \quad = \quad U_{adapt}$$

$$I_{Senke} \quad = \quad \frac{U_{adapt} - U_{GS(th),3}}{R_1}$$

FIG 6 zeigt schematisch eine Ausführungsform für den zweiten Stromverstärker $V_2$, der einen MOSFET $T_1$, einen Sourcewiderstand $R_2$, einen Gatewiderstand $R_3$ und eine Diode $D_1$ umfasst. Der MOSFET $T_1$, der Sourcewiderstand $R_2$ und der Gatewiderstand $R_3$ sind in der Art eines Sourcefolgers $V_2$ verbunden. Die eingangsseitig am Gate vorgeschaltete Diode $D_1$ gibt die Stromrichtung vor, so dass der Sourcefolger $V_2$ nur für einen positiven, d.h.: in Richtung des Gates fließenden Differenzstrom $\Delta I_{C1} = I_{C1} - I_{Senke}$ wirksam ist.

In einem nicht näher dargestellten Ausführungsbeispiel kann der MOSFET $T_1$ durch einen Bipolartransistor ersetzt sein. Dann wird der zweite Stromverstärker $V_2$ als Emitterfolger betrieben.

Mittels der Widerstände $R_2, R_3$ kann unter Berücksichtigung der Gate-Source-Schwellspannung $U_{GS(th),1}$ des MOSFET $T_1$ der Verstärkungsfaktor $v$ des zweiten Stromverstärkers $V_2$ wie folgt bestimmt werden:

$$v = \frac{R_3 - \dfrac{U_{GS(th),1}}{I_{C1} - I_{Senke}}}{R_2}$$

Für den Betrieb des Schalttransistors $T_2$ im Miller-Plateau und unter Vernachlässigung der parasitären Miller-Kapazität zwischen Gate-Elektrode und Kollektor-Elektrode ist

$$U_{GS(th),1} + I_{R_G} \cdot R_2 = (I_{C1} - I_{Senke}) \cdot R_3$$

wobei $I_{RG}$ der entlang des Schalttransistorgatewiderstands $R_G$ fließende Strom ist, welcher sich aus der negativen Versorgungsspannung $U_-$, die in FIG 6 beispielhaft mit minus 8 Volt angenommen ist, sowie aus der Miller-Plateau-Spannung $U_{Millerplateau,2}$ des Schalttransistors $T_2$ wie folgt ergibt:

$$I_{R_G} = \frac{\left(|U_-| + U_{Millerplateau,2}\right)}{R_G}$$

Durch Einsetzen der Strom-Spannungs-Beziehung am Schalttransistor $T_2$

$$I_{C1} = C_1 \cdot \frac{du}{dt} = I_{Senke} + \frac{U_{GS(th),1} + \dfrac{R_2}{R_G}\left(|U_-| + U_{Millerplateau,2}\right)}{R_3}$$

und unter Berücksichtigung der anhand von FIG 5 erklärten Beziehung für den Strom

$$I_{Senke} = \frac{U_{adapt} - U_{GS(th),3}}{R_1}$$

ergibt sich somit für die Spannungssteilheit der Kollektorspannung des Schalttransistors $T_2$ folgende Spannungssteilheitsbestimmungsgleichung:

$$\frac{du}{dt} = \frac{1}{C_1} \cdot \left( \frac{U_{GS(th),1} + \dfrac{R_2}{R_G}\left(|U_-| + U_{Millerplateau,2}\right)}{R_3} + \frac{U_{adapt} - U_{GS(th),3}}{R_1} \right)$$

Wie daraus erkennbar ist, kann die Spannungssteilheit $\frac{du}{dt}$ direkt über die einstellbare Spannungsquelle $U_{adapt}$ gesteuert werden.

Bei der Anwendung dieser Spannungssteilheitsbestimmungsgleichung ist zu berücksichtigen, dass für die Gate-Source-Schwellspannungen $U_{GS(th),1}, U_{GS(th),3}$ sowie für die Miller-Plateau-Spannung $U_{Millerplateau,2}$ nicht die Datenblattwerte einzusetzen sind, sondern dass diese Werte aus den Diagrammen der jeweiligen Bauteile für den jeweils einzustellenden Drainstrom beziehungsweise Kollektorstrom $I_C$ zu entnehmen sind.

Wird der zweite Stromverstärker $V_2$ mittels eines Bipolartransistors anstelle des MOSFET $T_1$ als Emitterfolger ausgeführt, so muss anstelle der Gate-Source-Schwellspannung $U_{GS(th),1}$ die Basis-Emitter-Spannung $U_{BE}$ des Bipolartransistors in die Spannungssteilheitsbestimmungsgleichung eingesetzt werden.

Die Funktionsweise der ersten Regelschaltung RS1 für die Regelung der Spannungssteilheit beim Einschaltvorgang gemäß FIG 3 ergibt sich in analoger Weise zu den Erklärungen für die zweite Regelschaltung RS2, wobei die Bauteile gemäß der Schaltung nach FIG 3 anstelle der Bauteile gemäß der Schaltung nach FIG 4 einzusetzen sind.

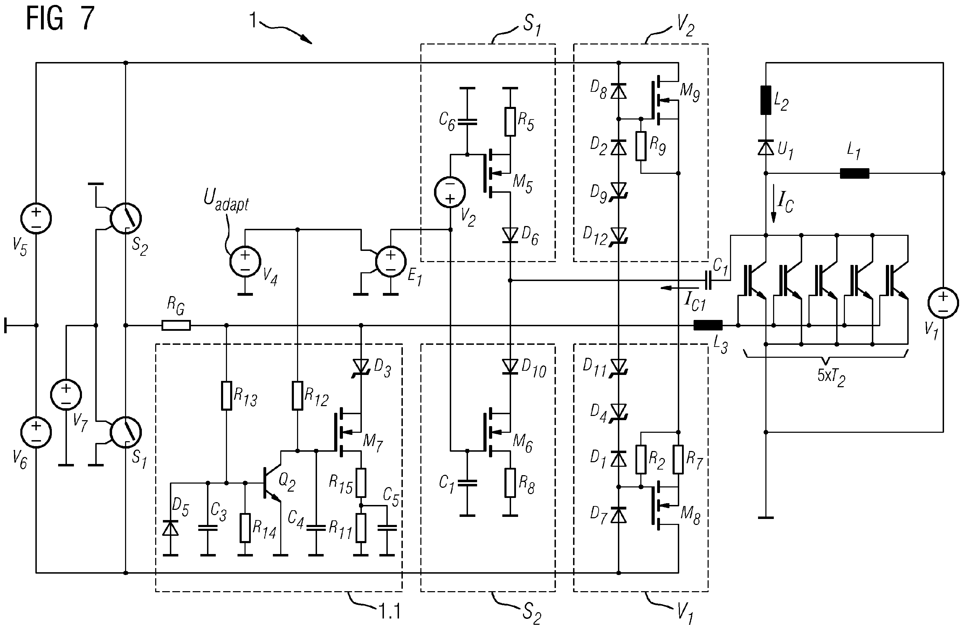

FIG 7 zeigt eine Schaltung für eine mittels des Simulationswerkzeugs LTSpice simulierte Simulationsschaltung 1 der ersten und der zweiten Regelschaltung RS1, RS2. Die Simulationsschaltung 1 umfasst eine Zusatzschaltung 1.1 für einen angepassten Einschaltübergang, die gateseitig des Schalttransistors $T_2$ angeordnet ist. Zudem weist die Simulationsschaltung 1 eine kathodenseitig der Freilaufdiode $U_1$ angeordnete erste Streuinduktivität $L2$ sowie eine gateseitig des Schalttransistors $T_2$ angeordnete zweite Streuinduktivität $L3$ auf, um eine anwendungsnahe Simulation des Schaltverhaltens zu ermöglichen.

Zur Simulation eines IGBT-Nennstroms von 200 Ampere wird der Schalttransistor $T_2$ durch eine Parallelschaltung von fünf einzelnen Transistoren nachgebildet, welche als Level-2 Modell eines 40 Ampere IGBT3 Trench-IGBT nach Angaben des Herstellers Infineon simuliert werden.

Die Simulationsschaltung 1 umfasst ferner als Schalter SW1, SW2 spannungsgesteuerte Schalter und wird mit einer bipolaren Treiberversorgung mit einer positiven Versorgungsspannung $U_+$ = 15 Volt und einer negativen Versorgungsspannung $U_-$ = **-8** Volt versorgt.

Die Zusatzschaltung 1.1 für einen angepassten Einschaltübergang ermöglicht einen gleitenden Übergang der Kollektorspannung $u$ vom sperrenden in den leitenden Zustand und verhindert oder vermindert eine Verzögerung der gewünschten Reduktion der Spannungssteilheit $\frac{du}{dt}$, die ansonsten aufgrund der Reaktionszeit des Stromverstärkers $V_1$ und der Streuinduktivität $L3$ bei schlagartigem Einschalten des Kollektorstroms $I_C$ verursacht werden würde. In einer Ausführungsform, bei der die Einhaltung einer maximalen Spannungssteilheit $\frac{du}{dt} \leq \frac{du}{dt}\Big|_{max}$ nicht gefordert ist, kann auf die Zusatzschaltung 1.1 verzichtet werden. Für den Ausschaltvorgang ist die Simulationsschaltung 1.1 nicht erforderlich, weil die Spannungssteilheit $\frac{du}{dt}$ beim Ausschalten langsam ansteigt und somit ein ausreichend schneller Regeleingriff des Stromverstärkers $V_2$ möglich ist.

In der Ausführungsform nach FIG 7 weist der zweite Verstärker $V_2$ einen Widerstand R7 auf. In vorteilhafter Weise bieten dieser Widerstand R7 und der Gatewiderstand $R_G$ des Treibers eine Dämpfung für den Schwingkreis, der aus der Gate-Kapazität des Schalttransistors $T_2$ und der Streuinduktivität $L3$ des Gatekreises gebildet wird. Im Gegensatz zur guten Dynamik der erfindungsgemäßen Schaltung verlieren aus dem Stand der Technik bekannte Operationsverstärkerschaltungen Schaltzeit und können nur einen geringen Gatestrom liefern. Auch aus dem Stand der Technik bekannte Treiber mit einer Gegentaktendstufe bieten aufgrund der prinzipbedingten Hysterese nur eine geringere Dynamik. Eine aus dem Stand der Technik bekannte schaltende Endstufe mit einer Induktivität im Gatekreis bietet ebenso nur eine gegenüber der Erfindung verminderte Dynamik und ist in der Umsetzung aufwändig und kostenintensiv.

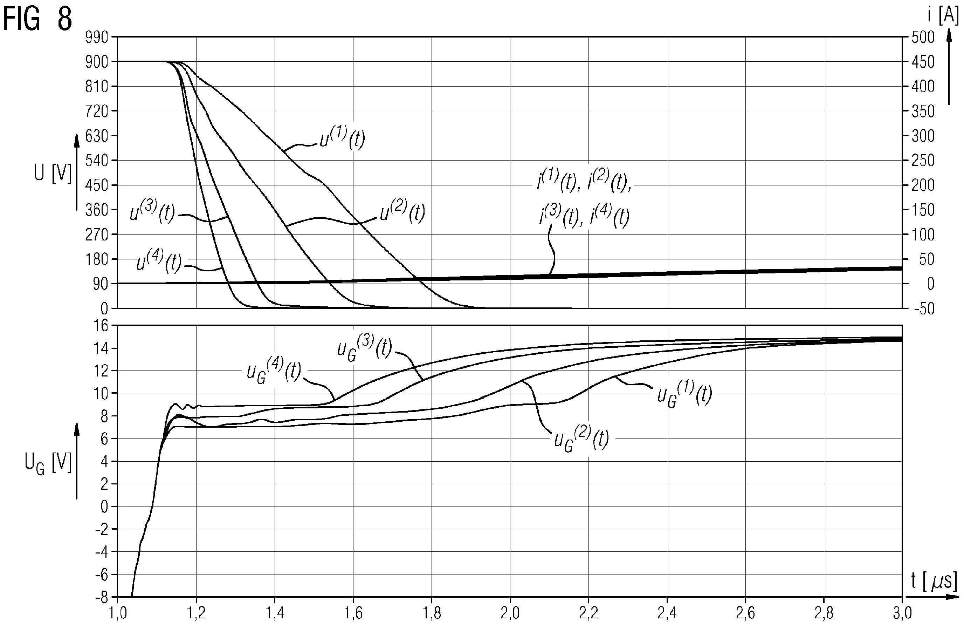

Figuren 8 bis 11 zeigen Ergebnisse der Simulation der Simulationsschaltung 1 mit dem Simulationswerkzeug LTSpice, wobei Änderungen der Kollektorspannung u, des vom Schalttransistor $T_2$ geschalteten Schaltstroms $i$ sowie der Gatespannung $u_G$ am Gate des Schalttransistors $T_2$ in Abhängigkeit der vom Schaltzeitpunkt gerechneten Zeit $t$. Jede der Figuren 8 bis 11 zeigt jeweils Kollektorspannungsverläufe $u^{(k)}(t)$, $k$ = 1...4, Schaltstromverläufe $i^{(k)}(t), k$ = 1...4 sowie Gatespannungsverläufe $u_G^{(k)}(t)$, $k$ = 1...4 für vier verschiedene Einstellungen der einstellbaren Spannungsquelle $U_{adapt}$, wodurch deren Einfluss auf die Spannungssteilheit $\frac{du}{dt}$ beim Schaltvorgang verdeutlicht wird. Der Index $k$ nimmt jeweils mit dem Spannungswert der einstellbaren Spannungsquelle $U_{adapt}$, und somit auch mit der Spannungssteilheit $\frac{du}{dt}$, zu.

FIG 8 zeigt Simulationsverläufe $u^{(k)}(t), u_G^{(k)}(t)$, $i^{(k)}(t)$, $k$ = 1...4 für die Simulation von Einschaltvorgängen des näherungsweise unbestromten Schalttransistors $T_2$. Je höher die Spannung der einstellbaren Spannungsquelle $U_{adapt}$ gewählt ist, d.h.: mit zunehmendem Index $k$, umso höher ist die Spannungssteilheit $\frac{du}{dt}$ des Kollektorspannungsverlaufs $u^{(k)}(t), k$ = 1... 4. Das Plateau der Gatespannungsverläufe $u_G^{(k)}(t)$, $k$ = 1...4 ist entsprechend unterschiedlich. Es kann mit dieser Ausführungsform die Spannungssteilheit $\frac{du}{dt}$ des Kollektorspannungsverlaufs $u^{(k)}(t), k$ = 1... 4 auf ein Viertel des Wertes reduziert werden, der ohne die Regelschaltungen RS1, RS2 erzielbar ist.

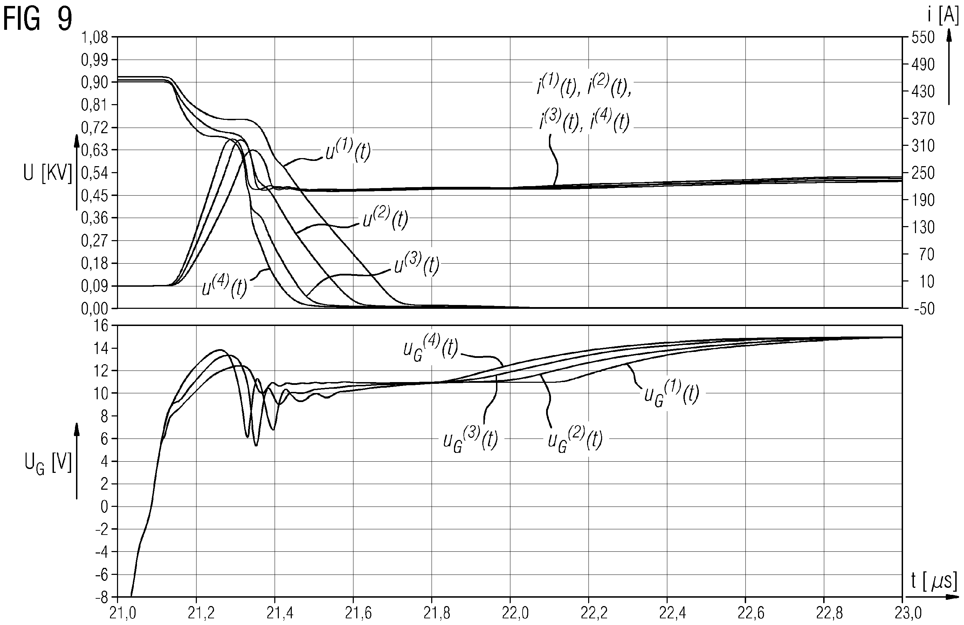

FIG 9 zeigt Simulationsverläufe $u^{(k)}(t)$, $u_G^{(k)}(t)$, $i^{(k)}(t)$, $k = 1...4$ für die Simulation von Einschaltvorgängen des Schalttransistors $T_2$ bei halber Nennstromstärke, d.h.: bei einer geschalteten Stromstärke von 200 Ampere.

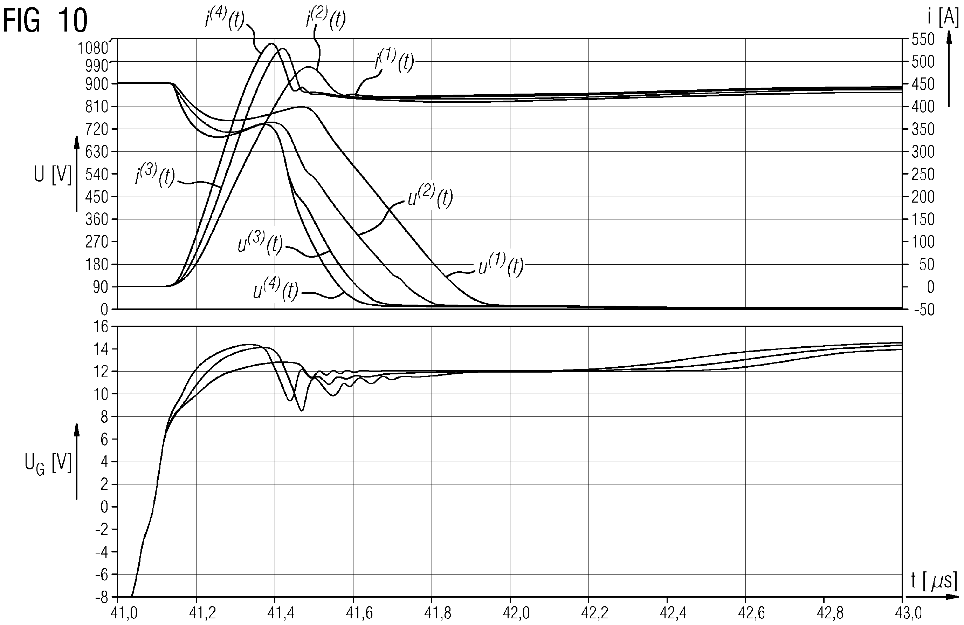

FIG 10 zeigt Simulationsverläufe $u^{(k)}(t)$, $u_G^{(k)}(t)$, $i^{(k)}(t)$, $k = 1...4$ für die Simulation von Einschaltvorgängen des Schalttransistors $T_2$ bei Nennstromstärke, d.h.: bei einer geschalteten Stromstärke von 400 Ampere.

Aus FIG 9 und FIG 10 ist ersichtlich, dass die Spannungssteilheit $\frac{du}{dt}$ mit zunehmender geschalteter Stromstärke abnimmt. Zugleich nimmt der Einfluss der Spannung der einstellbaren Spannungsquelle $U_{adapt}$ ab, insbesondere bei geringeren Spannungswerten, so dass sich die Spannungssteilheit $\frac{du}{dt}$ der Kollektorspannungsverläufe $u^{(k)}(t), k = 1...4$ bei höheren geschalteten Stromstärken weniger stark unterschiedet als bei niedrigeren geschalteten Stromstärken.

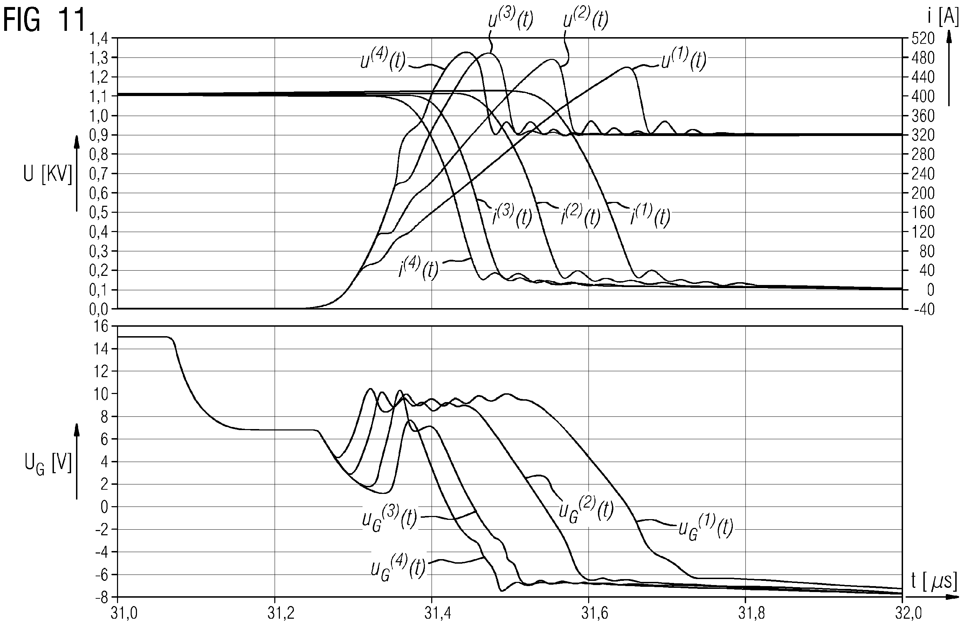

FIG 11 zeigt Simulationsverläufe $u^{(k)}(t)$, $u_G^{(k)}(t)$, $i^{(k)}(t)$, $k = 1...4$ für die Simulation von Ausschaltvorgängen des Schalttransistors $T_2$ bei Nennstromstärke, d.h.: bei einer geschalteten Stromstärke von 400 Ampere. Auch hier steigt mit höherer Spannung der einstellbaren Spannungsquelle $U_{adapt}$ die Spannungssteilheit $\frac{du}{dt}$ dem Betrag nach.

Zudem stellt sich auch hier ein unterschiedlich hohes Plateau der Gatespannungsverläufe $u_G^{(k)}(t)$, $k = 1...4$ s bei steigender Kollektorspannung $u$ ein.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1. Halbleiterschaltvorrichtung (1) umfassend einen über eine Gateelektrode entlang einer Kollektor-Emitter-Strecke schaltbaren Leistungshalbleiter ($T_2$) mit einem Kollektor, einem Emitter und einem Gate sowie mindestens eine Regelschaltung (RS1,RS2), die jeweils eine Stromsenke ($S_1,S_2$) und einen Stromverstärker ($V_1,V_2$) umfasst, wobei die Stromsenke ($S_1,S_2$) kapazitiv über einen Regelkondensator ($C_1$) mit dem Kollektor des Leistungshalbleiters ($T_2$) gekoppelt und zur Ableitung eines Teilstromes des bei einem Schaltvorgang über den Regelkondensator ($C_1$) fließenden Stromes bis zu einem einstellbaren Maximalstrom eingerichtet ist, welcher über eine einstellbare Spannungsquelle ($U_{adapt}$) einstellbar ist, und wobei der Stromverstärker ($V_1,V_2$) eingangsseitig mit dem kapazitiv mit dem Regelkondensator ($C_1$) gekoppelten Ende der Stromsenke ($S_1,S_2$) und mit einer positiven oder mit einer negativen Versorgungsspannung und ausgangsseitig mit der Gateelektrode des Leistungshalbleiters ($T_2$) verbunden und derart eingerichtet ist, dass der von der Stromsenke ($S_1,S_2$) nicht abgeleitete Teilstrom des bei einem Schaltvorgang über den Regelkondensator ($C_1$) fließenden Stromes um einen vorbestimmten Verstärkungsfaktor verstärkt und in die Gateelektrode des Leistungshalbleiters ($T_2$) derart eingeleitet wird, dass der Änderung der Spannung über der Kollektor-Emitter-Strecke des Leistungshalbleiters ($T_2$) bei einem Schaltvorgang entgegengewirkt wird.

2. Halbleiterschaltvorrichtung (1) nach Anspruch 1, umfassend eine erste Regelschaltung (RS1) mit einem ersten Stromverstärker ($V_1$) und eine zweite Regelschaltung (RS2) mit einem zweiten Stromverstärker ($V_2$), wobei der erste Stromverstärker ($V_1$) mit der negativen Versorgungsspannung verbunden und zur Einspeisung eines negativen Stromes in die Gateelektrode des Leistungshalbleiters ($T_2$) eingerichtet ist und der zweite Stromverstärker ($V_2$) mit der positiven Versorgungsspannung verbunden und zur Einspeisung eines positiven Stromes in die Gateelektrode des Leistungshalbleiters ($T_2$) eingerichtet ist.

3. Halbleiterschaltvorrichtung (1) nach einem der vorhergehenden Ansprüche, **dadurch gekennzeichnet, dass** eine Stromsenke ($S_1,S_2$) einen in Stromgegenkopplung geschalteten Metalloxid-Halbleiter-Feldeffekttransistor (MOSFET) ($T_3$), einen Stromgegenkopplungswiderstand ($R_1$) sowie eine einstellbare Spannungsquelle ($U_{adapt}$) umfasst, wobei die Drainelektrode des MOSFET ($T_3$) mit dem Regelkondensator ($C_1$) und die Sourceelektrode des MOSFET ($T_3$) über den Stromgegenkopplungswiderstand ($R_1$) mit Masse verbunden ist und die Gateelektrode des MOSFET ($T_3$) von der gegen Masse referenzierten einstellbaren Spannungsquelle ($U_{adapt}$) gespeist wird.

4. Halbleiterschaltvorrichtung (1) nach einem der vorhergehenden Ansprüche, **dadurch gekennzeich- net**, dass ein Stromverstärker ($V_1$, $V_2$) einen als Sourcefolger geschalteten MOSFET ($T_1$), einen Gatewiderstand ($R_3$), einen Sourcewiderstand ($R_2$) sowie eine Diode ($D_1$) umfasst, wobei die Diode ($D_1$) in Durchlassrichtung auf die Gateelektrode des MOSFET ($T_1$) weisend zwischen dem Regelkondensator ($C_1$) und der Gateelektrode des MOSFET ($T_1$) angeordnet ist, wobei der Gatewiderstand ($R_3$) zwischen der Gatelektrode des MOSFET ($T_1$) und der Gatelektrode des Leistungshalbleiters ($T_2$) angeordnet ist und wobei der Sourcewiderstand ($R_2$) zwischen der Sourceelektrode des MOSFET ($T_1$) und der Gatelektrode des Leistungshalbleiters ($T_2$) angeordnet ist.

5. Halbleiterschaltvorrichtung (1) nach Anspruch 4, wobei der als Sourcefolger geschaltete MOSFET ($T_1$) durch einen als Emitterfolger geschalteten Bipolartransistor ersetzt ist.

6. Halbleiterschaltvorrichtung (1) nach einem der vorhergehenden Ansprüche, umfassend eine Zusatzschaltung (1.1) für einen angepassten Einschaltübergang, die mit der Gateelektrode des Leistungshalbleiters ($T_2$) verbunden und die für einen gleitenden Übergang der Kollektorspannung des Leistungshalbleiters ($T_2$) beim Umschalten von dessen Kollektor-Emitter-Strecke von einem gesperrten in einen leitenden Zustand eingerichtet ist.

7. Halbleiterschaltvorrichtung (1) nach einem der vorhergehenden Ansprüche, **dadurch gekennzeich- net**, dass der Leistungshalbleiter ($T_2$) als Bipolartransistor mit isolierter Gateelektrode (IGBT), als Metalloxid-Halbleiter-Feldeffekttransistor (MOSFET), als Siliciumcarbid Metalloxid-Halbleiter-Feldeffekttransistor (SiC MOSFET) oder als Bipolartransistor ausgebildet ist.

8. Frequenzumrichter umfassend eine Halbleiterschaltvorrichtung (1) nach einem der vorhergehenden Ansprüche, wobei der Leistungshalbleiter ($T_2$) als IGBT ausgebildet ist.

## FIG 1
(Stand der Technik)

$\frac{du}{dt}$, $E_{ON}$

$E_{ON}$

$\frac{du}{dt}$

$I_C$

## FIG 2
(Stand der Technik)

$\frac{du}{dt}$, $E_{OFF}$

$\frac{du}{dt}$

$E_{OFF}$

$I_C$

EP 3 736 982 A1

FIG 4

FIG 3

FIG 5

FIG 6

$$I_A = V \cdot I_E$$

$$I \leq I_{soll}$$

EP 3 736 982 A1

FIG 7

EP 3 736 982 A1

FIG 8

EP 3 736 982 A1

FIG 9

FIG 10

FIG 11

EP 3 736 982 A1

# EP 3 736 982 A1

Europäisches Patentamt
European Patent Office
Office européen des brevets

## EUROPÄISCHER RECHERCHENBERICHT

Nummer der Anmeldung

EP 19 17 2967

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2011/149632 A2 (STANDARD MICROSYST SMC [US]; ILLEGEMS PAUL F [US]) 1. Dezember 2011 (2011-12-01) | 1-5,7 | INV. H03K17/082 H03K17/16 |
| A | * Abbildungen 8,9,10 * ----- | 6,8 | |
| X | DE 10 2018 007011 A1 (INFINEON TECHNOLOGIES AUSTRIA AG [AT]) 7. März 2019 (2019-03-07) * Absatz [0002]; Abbildungen 5,6 * ----- | 1-5,7,8 | |
| A | US 6 137 329 A (KARDASH JOHN J [US]) 24. Oktober 2000 (2000-10-24) * Abbildungen 2,5,6,7 * ----- | 1-8 | |
| A | EP 2 816 728 A1 (ABB RESEARCH LTD [CH]) 24. Dezember 2014 (2014-12-24) * Abbildung 3 * ----- | 1-8 | |
| A | WO 02/47265 A2 (RUBITEC GESELLSCHAFT FUER INNOVATION & TECHNOLOGIE RUHR UNIV BOCHUM MB) 13. Juni 2002 (2002-06-13) * Abbildungen 1,2,4,6,7,9,13,14 * ----- | 1-8 | RECHERCHIERTE SACHGEBIETE (IPC) H03K H02M |
| A | SHIHONG PARK ET AL: "Flexible dv/dt and di/dt control method for insulated gate power switches", CONFERENCE RECORD OF THE 2001 IEEE INDUSTRY APPLICATIONS CONFERENCE. 36TH IAS ANNUAL MEETING . CHICAGO, IL, SEPT. 30 - OCT. 4, 2001; [CONFERENCE RECORD OF THE IEEE INDUSTRY APPLICATIONS CONFERENCE. IAS ANNUAL MEETING], NEW YORK, NY : IEEE, US, 30. September 2001 (2001-09-30), Seite 1038, XP032142858, DOI: 10.1109/IAS.2001.955592 ISBN: 978-0-7803-7114-9 * das ganze Dokument * ----- -/-- | 1-8 | |

Der vorliegende Recherchenbericht wurde für alle Patentansprüche erstellt

| Recherchenort | Abschlußdatum der Recherche | Prüfer |
|---|---|---|
| Den Haag | 5. November 2019 | O'Reilly, Siobhan |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

Seite 1 von 2

19

Europäisches Patentamt

European Patent Office

Office européen des brevets

# EUROPÄISCHER RECHERCHENBERICHT

Nummer der Anmeldung

EP 19 17 2967

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | DE 34 20 008 A1 (GEN ELECTRIC [US]) 6. Dezember 1984 (1984-12-06) * Abbildung 1d * ----- | 1-8 | |
| A | DE 10 2014 214260 A1 (FRAUNHOFER GES ZUR FÖRDERUNG DER ANGEWANDTEN FORSCHUNG E V [DE]) 29. Oktober 2015 (2015-10-29) * Absatz [0003]; Abbildungen 7, 13 * ----- | 1-8 | |

RECHERCHIERTE SACHGEBIETE (IPC)

Der vorliegende Recherchenbericht wurde für alle Patentansprüche erstellt

| Recherchenort | Abschlußdatum der Recherche | Prüfer |
|---|---|---|
| Den Haag | 5. November 2019 | O'Reilly, Siobhan |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
..........................................................................
& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 19 17 2967

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

05-11-2019

| Im Recherchenbericht angeführtes Patentdokument | Datum der Veröffentlichung | Mitglied(er) der Patentfamilie | Datum der Veröffentlichung |
|---|---|---|---|
| WO 2011149632 A2 | 01-12-2011 | US 2011291707 A1<br>WO 2011149632 A2 | 01-12-2011<br>01-12-2011 |
| DE 102018007011 A1 | 07-03-2019 | CN 109473950 A<br>DE 102018007011 A1<br>US 2019074827 A1 | 15-03-2019<br>07-03-2019<br>07-03-2019 |
| US 6137329 A | 24-10-2000 | KEINE | |
| EP 2816728 A1 | 24-12-2014 | CN 104242890 A<br>EP 2816728 A1<br>US 2014375362 A1 | 24-12-2014<br>24-12-2014<br>25-12-2014 |
| WO 0247265 A2 | 13-06-2002 | DE 10061563 A1<br>US 2004085117 A1<br>WO 0247265 A2 | 27-06-2002<br>06-05-2004<br>13-06-2002 |
| DE 3420008 A1 | 06-12-1984 | BE 899755 A<br>BR 8402665 A<br>DE 3420008 A1<br>FR 2547134 A1<br>GB 2140996 A<br>JP S6041323 A<br>NL 8401735 A<br>US 4540893 A | 26-11-1984<br>07-05-1985<br>06-12-1984<br>07-12-1984<br>05-12-1984<br>05-03-1985<br>17-12-1984<br>10-09-1985 |
| DE 102014214260 A1 | 29-10-2015 | DE 102014214246 B3<br>DE 102014214252 B3<br>DE 102014214260 A1<br>US 2017040802 A1<br>US 2017104338 A1<br>US 2017104339 A1<br>WO 2015162044 A1<br>WO 2015162045 A1<br>WO 2015162046 A1 | 09-07-2015<br>09-07-2015<br>29-10-2015<br>09-02-2017<br>13-04-2017<br>13-04-2017<br>29-10-2015<br>29-10-2015<br>29-10-2015 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10211075 A1
- DE 102005012151 B3